# FASCICULE DE BREVET EUROPEEN

(11) **EP 3 042 320 B1**
(45) Date de publication et mention de la délivrance du brevet: **07.11.2018**
(21) Numéro de dépôt: 14758927.9
(22) Date de dépôt: 03.09.2014
(51) Int. Cl.: G06F 17/50

(54) **PROCÉDÉ D'ANALYSE DU COMPORTEMENT D'UN CIRCUIT INTÉGRÉ MIS EN OEUVRE PAR ORDINATEUR**
VERFAHREN ZUR ANALYSE DES VERHALTENS EINER INTEGRIERTEN SCHALTUNG DURCH EINEN RECHNER
METHOD OF ANALYSING THE BEHAVIOUR OF AN INTEGRATED CIRCUIT IMPLEMENTED BY COMPUTER

(30) Priorité: 05.09.2013 FR 1358534
(43) Date de publication de la demande: 13.07.2016
(73) Titulaire: Commissariat à l'Énergie Atomique et aux Énergies Alternatives, 75015 Paris (FR)
(72) Inventeur: HERON, Olivier, F-78830 Bullion (FR); SANDIONIGI, Chiara, F-75013 Paris (FR)
(74) Mandataire: Lopez, Frédérique
(86) Numéro de dépôt international: PCT/EP2014/068759
(87) Numéro de publication internationale: WO 2015/032829

(56) Documents cités:
- US-A1- 2004 019 859
- GUPTA S ET AL: "Energy and peak-current per-cycle estimation at RTL", IEEE TRANSACTIONS ON VERY LARGE SCALE INTEGRATION (VLSI) SYSTEMS, IEEE SERVICE CENTER, PISCATAWAY, NJ, USA, vol. 11, no. 4, 1 août 2003 (2003-08-01), pages 525-537, XP011100551, ISSN: 1063-8210, DOI: 10.1109/TVLSI.2002.800534
- ALESSANDRO BOGLIOLO ET AL: "Regression-based RTL power modeling", ACM TRANSACTIONS ON DESIGN AUTOMATION OF ELECTRONIC SYSTEMS, vol. 5, no. 3, 31 juillet 2000 (2000-07-31), pages 337-372, XP058039299, ISSN: 1084-4309, DOI: 10.1145/348019.348081
- GUPTA S ET AL: "Power Macromodeling For High Level Power Estimation", PROCEEDINGS OF THE DESIGN AUTOMATION CONFERENCE. ANAHEIM, JUNE 9 - 13, 1997; [PROCEEDINGS OF THE DESIGN AUTOMATION CONFERENCE], NEW YORK, ACM, US, vol. CONF. 34, 9 juin 1997 (1997-06-09), pages 365-370, XP010227610, DOI: 10.1145/266021.266171 ISBN: 978-0-7803-4093-0

## Description

Le domaine de l'invention est celui de la conception de circuits intégrés. De manière générale, la conception d'un circuit intégré (CI) suit une approche descendante. Elle débute par exemple par une description semi comportementale-structurelle et se termine par une description détaillée de sa réalisation matérielle. A chaque étape de développement, une phase de vérification valide la description faite du CI vis-à-vis du cahier des charges. La vérification consiste notamment à simuler le comportement du CI. La simulation d'une description abstraite est plus rapide que la simulation d'une réalisation détaillée du CI.

Au niveau transfert de registre encore appelé « Register transfer level » (RTL), le système est généralement formé de registres, de machines à états finis, de fonctions combinatoires et de signaux qui relient les autres entités entre-elles. Au niveau inférieur, porte logique, le système est composé de registres, cellules logiques (par exemple ET, OU, NON-OU-ET, etc.) et de signaux. La description contient les composants physiques déjà représentés au niveau supérieur et de nouveaux composants physiques.

De manière générale, la notion de composant physique recouvre une ligne de métal sur laquelle se propage un signal ou une cellule logique (porte, bascule, multiplexeur, etc.) et la notion de chemin est définie au niveau porte logique ou porte. Le chemin est la composition série signal-cellule-signal-cellule-etc..., entre la sortie de donnée d'un registre et l'entrée de donnée d'un autre registre.

La plupart des travaux qui traitent le problème de l'estimation de caractéristiques temporelles au niveau RTL et supérieur, assignent/annotent des valeurs aux composants physiques RTL qui ont été estimées avec des techniques basées sur une caractérisation préalable du chemin physique le plus long ou d'autres techniques, tel que décrit notamment dans l'article de : Anand Raghunathan, Sujit Dey, and Niraj K. Jha "High-Level Macro-Modeling and Estimation Techniques for Switching Activity and Power Consumption", IEEE Transactions On Very Large Scale Integration (VLSI) Systems, Vol. 11, No. 4, August 2003.

Quelle que soit l'approche adoptée, l'estimation du temps de propagation d'un signal entre deux registres au niveau RTL est la somme des temps (annotés) des composants physiques traversés par le signal.

La précision de ces approches n'est plus satisfaisante lorsque les paramètres physiques de certains composants par exemple des transistors, varient au cours du temps (par exemple les effets du vieillissement ou de la température). La variation n'étant pas uniformément répartie sur l'ensemble des transistors et de fait des chemins, le temps de propagation du signal dépend du chemin emprunté. Pour certains chemins, leurs marges temporelles peuvent être violées ce qui entraîne une erreur logique. Sous la condition d'une variation des paramètres physiques des transistors, il est nécessaire de conserver la topologie des chemins au niveau RTL et supérieur.

Dans ce contexte général, l'objectif est de calculer des paramètres physiques du chemin d'un CI à partir de la connaissance des paramètres physiques des composants physiques constituants le chemin au niveau RTL (ou supérieur).

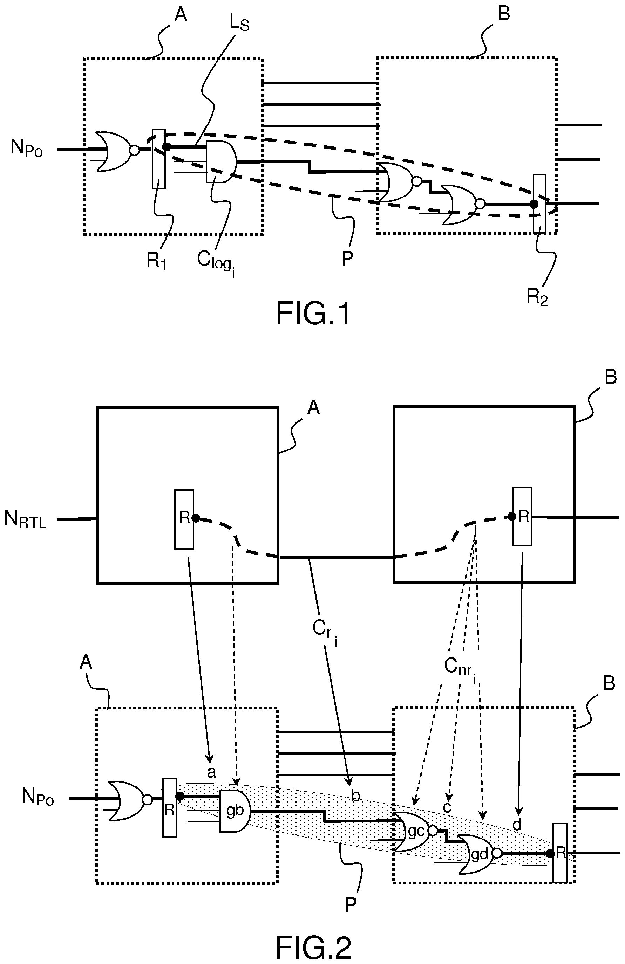

La figure 1 illustre, au niveau d'abstraction porte N_{Po}, les signaux (source, intermédiaire et terminaison) d'un chemin P qui sont inclus dans un même module, ou sont répartis dans plusieurs modules, en l'occurrence sur la figure 1, un module A et un module B, un module regroupant les composants physiques permettant de réaliser une fonction.

Le chemin P montre la ligne de métal sur laquelle se propage un signal, référencée Ls. Le chemin illustré P traverse les modules A et B, lesdits modules comportant également des cellules logiques C_{log i.}

A ce niveau d'abstraction, tous les composants physiques (ligne de métal, cellules logiques, ...) constituants les chemins sont décrits, cela permet d'évaluer directement leurs paramètres physiques, par exemple avec l'aide d'une simulation du CI.

Le paramètre physique du chemin est une combinaison des paramètres physiques des composants physiques.

Un paramètre physique peut être la fréquence de commutation d'un signal, la caractéristique temporelle d'une cellule, le rapport cyclique d'un signal, etc...

Aux niveaux d'abstraction supérieurs, le nombre de composants physiques décrits est inférieur. Ceux représentés sont appelés composants physiques représentés : leur description existe dans les deux niveaux d'abstraction.

La figure 2 met ainsi en parallèle, le niveau d'abstraction porte N_{Po} et un niveau d'abstraction RTL : N_{RTL}, avec des composants physiques non représentés qui sont appelés composants physiques non représentés Cₙᵣᵢ (repérés en traits pointillés) dont les paramètre physiques ne peuvent pas être évalués et des composants physiques représentés Cᵣᵢ (repérés en traits pleins).

Un chemin comportant des composants physiques non-représentés est appelé chemin incomplet au niveau RTL, et est illustré sur la figure 2, par le chemin « a-gb-b-gc-c-gd-d ».

Les composants physiques représentés (a, b et d) sont ainsi repérés en traits pleins, alors que ceux non représentés (gb, gc, c et gd) sont repérés en traits pointillés.

Au niveau RTL, seul le paramètre physique des signaux a, b et d peut être évalué. Un paramètre physique du chemin P : « a-gb-b-gc-c-gd-d » peut être déterminé au niveau RTL à partir de celui connu de ces signaux seulement.

Il est clair que le résultat diverge de la valeur calculée au niveau porte. La divergence est aggravée sur les chemins contenant un grand nombre de composants physiques.

Dans ce contexte, le problème que cherche à résoudre la présente invention est de réaliser l'estimation des paramètres physiques des composants physiques non représentés au niveau RTL et supérieur.

Il a déjà été décrit et notamment dans les articles de V. Huard et al., « A prédictive bottom-up hierarchical approach to digital system reliability", Reliability Physics Symposium (IRPS), 2012 IEEE International et de Clement Bertolini, Olivier Héron, Nicolas Ventroux, François Marc, "Relation between HCl-induced performance degradation and applications in a RISC processor", IOLTS 2012, une méthode pour l'estimation de la dégradation temporelle des cellules logiques et des chemins d'un circuit intégré au niveau porte. Les auteurs présentent une équation qui permet de calculer la dégradation temporelle d'une cellule logique en fonction de l'activité de ses signaux d'entrée. Le procédé inclut les étapes suivantes : description du circuit, simulation du circuit, extraction des chemins physiques et de leur caractéristique temporelle, extraction de l'activité des signaux et calcul de la dégradation des chemins. Cette solution ne permet néanmoins pas de résoudre le problème posé dans la présente invention, car elle ne traite pas le problème de l'estimation des paramètres physiques des chemins à plus haut niveau d'abstraction.

Le brevet US7836418B2, présente un procédé qui inclut une étape dans laquelle un chemin est assigné à des modules dans une description hiérarchique du circuit. Cette assignation est triviale puisque le nom des modules est inclus dans la description détaillée du circuit. Ce procédé inclut une étape dans laquelle il associe un paramètre physique à uniquement, certains signaux d'un chemin. Les signaux candidats sont ceux situés à l'entrée et à la sortie d'un module. Le paramètre physique est déterminé avec l'aide d'une analyse du chemin.

Il a également été décrit dans l'article de Sheng Li, Jung Ho Ahn, Jay B. Brockman, Norman P. Jouppi, "McPAT: An Integrated Power, Area, and Timing Modeling Framework for Multicore Architectures", Micro'09 & technical report V1.0, un environnement logiciel pour modéliser surface, délais et consommation d'énergie d'un circuit multi-coeur à différents niveaux d'abstraction. L'utilisateur entre des paramètres physiques liés aux caractéristiques géométriques et physiques qui sont ensuite assignés aux composants physiques du circuit dans le but de modéliser ces propriétés. L'environnement génère les descriptions aux différents niveaux d'abstraction. A chaque niveau, les composants physiques recevront une valeur unique de paramètre physique préalablement calculé par le logiciel. L'estimation du temps de propagation des signaux aux niveaux d'abstraction supérieurs ne considère pas le chemin emprunté par ces signaux.

La demande de brevet US20060253814 présente un procédé qui inclut une étape (108) dans laquelle certains chemins du circuit sont « placés » dans des tableaux choisi parmi un ensemble de tableaux. Un tableau est référencé par les bornes d'une plage de valeurs de temps. Pour un chemin donné, le critère de choix du tableau est une comparaison entre le temps du chemin et les bornes de temps du tableau. Le tableau contient le nom d'un composant physique. Le composant physique sélectionné sera inséré sur le chemin (à partir d'une bibliothèque préalablement fournie). Cette étape revient à chercher une entrée dans un tableau associatif dont la clef est les deux bornes de temps puis d'assigner le contenu au chemin courant. Néanmoins, ce procédé ne nécessite pas la connaissance détaillée des composants physiques constituants le chemin. Elle ne permet donc pas de résoudre le problème de l'assignation d'un paramètre physique spécifique à chaque composant physique d'un chemin.

L'article des auteurs : O. Heron et al. « On the simulation of HCl-induced variations of IC timings at high level », Journ. Of Electronic Testing: Theory & App., to appear, divulgue une méthode pour l'estimation de la dégradation temporelle de tous les chemins internes d'un processeur au niveau d'abstraction fonctionnelle. La solution propose le procédé suivant ; i) la génération de la trace des instructions lues par le processeur à l'aide d'une simulation, ii) pour chaque instruction et pour chaque chemin, l'instruction lue entre dans une table qui fournit en sortie une valeur d'activité du chemin (combinaison de l'activité tous les signaux du chemin), et iii) pour chaque chemin et pour la valeur d'activité sélectionnée, le calcul de l'incrément de dégradation temporelle du chemin due à cette instruction. La table en question est préalablement construite avec l'aide d'une caractérisation de l'activité des chemins avec plusieurs patterns d'instructions.

Cette solution résout seulement le problème de l'estimation de paramètres physiques des chemins appartenant exclusivement au processeur. En effet, la solution n'emploie pas un procédé qui permet d'identifier les composants physiques non représentés traversés par un chemin. Cette absence empêche l'opération qui assigne judicieusement un paramètre physique à chaque composant physique du chemin. Cette solution ne permet pas de résoudre le problème pour des chemins répartis entre au moins deux modules.

L'article des auteurs Gupta et al: "Energy and peak-current per-cycle estimation at RTL", IEEE TRANSACTIONS ON VERY LARGE SCALE INTEGRATION (VLSI) SYSTEMS, divulgue un procédé d'analyse du comportement d'un circuit intégré comprenant des chemins et composants physiques, lesdits composants physiques étant soit non représentés dans un premier niveau d'abstraction au moins égal ou supérieur au niveau RTL, soit représentés dans ledit premier niveau d'abstraction, ledit circuit intégré comprenant un ensemble de modules constitués de composants physiques, chaque module définissant une fonction entre un signal d'entrée et un signal de sortie, les composants physiques, les chemins et les modules étant identifiés chacun par un nom.

Ainsi dans ce contexte, la présente invention a pour objet un procédé permettant l'évaluation de paramètre physique de l'ensemble des composants physiques d'un circuit intégré, et ce à un niveau d'abstraction supérieur à celui du niveau porte.

Plus précisément, il s'agit d'un procédé d'analyse du comportement d'un circuit intégré comprenant des chemins et composants physiques, mis en oeuvre par ordinateur selon la revendication 1.

Selon une variante de l'invention, les paramètres physiques des composants physiques représentés sont obtenus par simulation/analyse du circuit au niveau supérieur.

Selon une variante de l'invention, l'assignation d'un module à un composant physique représenté est réalisée par l'analyse de la hiérarchie du circuit intégré au niveau porte. A ce niveau d'abstraction, la description du circuit intégré détaille l'appartenance des composants physiques aux modules.

L'invention a aussi pour objet un programme d'ordinateur comportant des instructions pour l'exécution du procédé d'analyse du comportement d'un circuit intégré mis en oeuvre par ordinateur, selon l'invention, lorsque le programme est exécuté par un processeur.

L'invention a encore pour objet un module de conception destiné à être embarqué dans un circuit intégré comportant au moins une unité de calcul et une mémoire, mettant en oeuvre le procédé d'analyse du comportement d'un circuit intégré mis en oeuvre par ordinateur selon l'invention.

L'invention sera mieux comprise et d'autres avantages apparaitront à la lecture de la description qui va suivre donnée à titre non limitatif et grâce aux figures annexées parmi lesquelles :
- la figure 1 illustre un exemple de chemin au niveau d'abstraction porte ;
- la figure 2 met en parallèle le chemin illustré en figure 1 et ce même chemin dans un niveau d'abstraction RTL ;
- la figure 3 illustre les principales étapes du procédé de la présente invention ;
- la figure 4 illustre plus en détails l'opération d'association du tableau de labellisation et des quatrième et cinquième tableaux associatifs de manière à définir le sixième tableau associatif ;
- la figure 5 illustre un exemple de circuit intégré composé d'un chemin réparti sur deux modules dans lequel seuls sont considérés les signaux le long dudit chemin.

Le procédé de la présente invention offre l'avantage de pouvoir s'appliquer à différents niveaux d'abstraction supérieurs au niveau porte et sa réalisation est indépendante du circuit étudié. Il permet de combiner des paramètres physiques relatifs aux chemins (par exemple dégradation du temps de propagation des signaux sur le chemin) et ceux indépendants de la notion de chemin (température dissipée d'un ensemble de composant physiques)

Il peut être mis en oeuvre avec un logiciel exécutable sur une machine ou bibliothèque logicielle pouvant être couplées à d'autres logiciels de simulation existants pour effectuer l'estimation de la dégradation temporelle des chemins d'un système embarqué à des niveaux supérieurs par exemple, niveau RTL et niveau transactionnel TLM (transactionnel-comportemental).

Le procédé de la présente invention permet d'envisager les avantages suivants au niveau de la conception :
- l'estimation de la dégradation dès les premiers cycles de développement du système : levée tôt des risques et de l'incertitude à propos de l'impact des choix de conception et de la technologie sur le circuit final ;
- l'effort d'analyse et l'expertise peuvent être transférés à l'outil ;
- une amélioration in fine de la productivité du concepteur ;
- une exploration d'un grand nombre de configurations de l'architecture incluant l'identification des configurations qui affectent le plus (ou le moins) la performance et la fiabilité du système, cette exploration pouvant également se faire sans la connaissance de la technologie et permettant de procéder alors seulement à une analyse comparative entre deux choix de conception.

Le procédé décrit comprend notamment et avantageusement l'estimation d'un ou plusieurs paramètres physiques des composants physiques non représentés constituants un chemin au niveau d'abstraction RTL ou supérieur. La sortie est un tableau associatif contenant les paramètres physiques nécessaires au calcul des paramètres physiques des chemins et du CI au niveau d'abstraction RTL et supérieur.

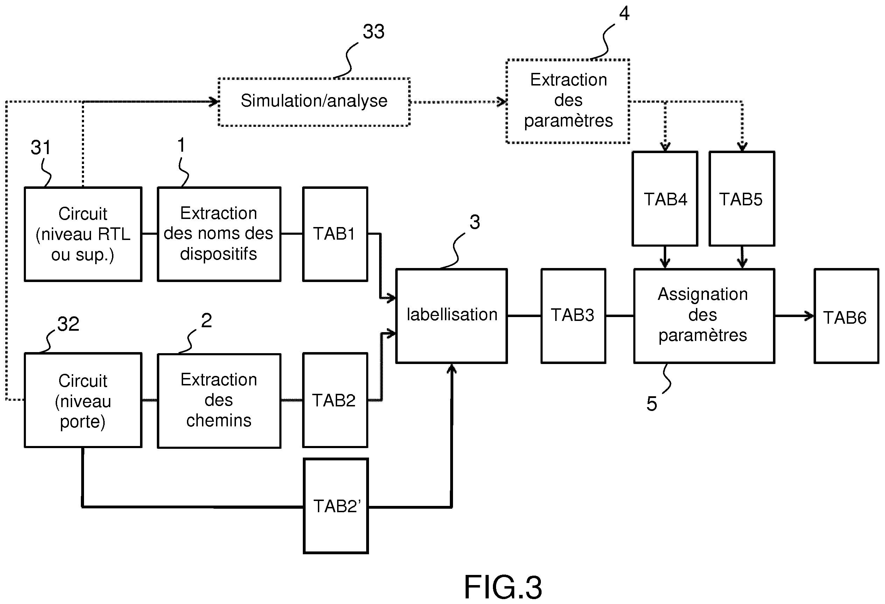

Le déroulement du procédé est illustré en figure 3. Il se décompose principalement en 5 étapes :
Etape 1 : L'extraction 1 du nom dans la présente description, des composants physiques décrits au niveau RTL (ou supérieur) 31, donc des composants physiques représentés, ainsi que les noms des modules. La sortie est un tableau TAB1 (détaillé ci-après).
Etape 2 : L'extraction 2 du nom des composants physiques d'un chemin du circuit au niveau porte logique 32. La sortie est un tableau associatif TAB2 (détaillé ci-après).
En parallèle, il a été établi un tableau associatif des noms des composants physiques et des noms de leur module d'appartenance, à partir de la description détaillée du circuit intégré.
Etape 3 : La labellisation 3 des noms des composants physiques des chemins (TAB2) avec le nom des composants physiques connus ou module connu dans le tableau TAB1. La sortie est un tableau associatif TAB3 (détaillé ci-après).
Etape 4 : L'extraction 4 des paramètres physiques des résultats de simulation/analyse du circuit au niveau supérieur. La sortie est composée de tableaux associatifs contenant les paramètres physiques des composants physiques décrits au niveau visé (TAB4 et TAB5).
Etape 5 : L'assignation 5 des paramètres physiques contenus dans les tableaux TAB4 et TAB5 aux signaux labellisés des chemins dans TAB3. La sortie est le tableau associatif TAB6.

Avantageusement, le procédé est renouvelé lorsque les entrées changent : modification de la description du circuit ou exécution d'une nouvelle simulation (modification des tableaux TAB4 et TAB5).

Les différentes étapes sont décrites ci-après plus en détails :

### Etape 1 :

Cette étape consiste à analyser la description du circuit (par exemple en langage VHDL ou VERILOG ou SystemC ou SystemVERILOG) et à extraire le nom des modules et celui des composants physiques représentés (NAME). La sortie est une liste de noms écrite dans le tableau TAB1 suivant (les entrées du tableau sont repérées par des indices (0, 1, ...) :

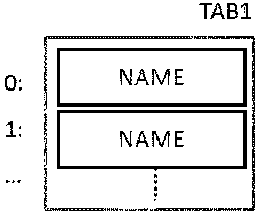

### Etape 2 :

Cette étape consiste tout d'abord à analyser la description matérielle du circuit (par exemple en langage VHDL ou VERILOG) et à extraire la liste des chemins (comme défini ci-dessus). Il existe des algorithmes et outils capables d'effectuer cette opération. Le procédé écrit chaque chemin dans un tableau associatif TAB2. Une entrée est créée pour chaque chemin identifié. Le champ clef comporte le nom du chemin (Path). Pour chaque entrée, le nombre de champs de valeurs est égal au nombre de composants physiques constituants le chemin. Un champ de valeur mémorise le nom du composant physique (name). L'ordre d'arrangement des composants physiques n'a pas d'importance.

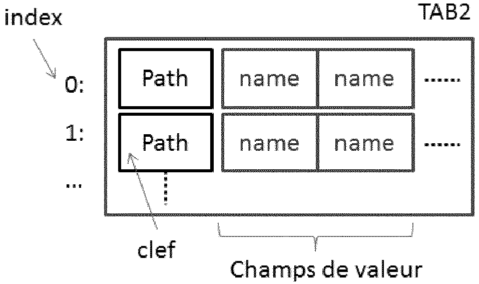

### Etape 3 :

Cette étape est une étape de labellisation qui discrimine les composants physiques représentés et non représentés au niveau supérieur considéré. L'opération consiste à labelliser les noms des composants physiques de TAB2 (par exemple le composant physique d illustré en figure 2) avec des noms listés dans TAB1.

Un composant physique de TAB2 est représenté si son nom apparait dans les tableaux TAB2 et TAB1 sinon il sera qualifié de non représenté. Lorsqu'il s'agit d'un composant physique représenté, le label sera son nom. Lorsqu'il s'agit d'un composant physique non représenté, le label sera le nom du module parent qui inclut le composant physique non représenté et dont le nom est listé dans TAB1.

Ainsi, le nom d'un composant physique non représenté au niveau porte est labellisé avec le nom du module RTL (parent) qui inclut ce composant physique.

L'identification du module parent peut avoir été préalablement obtenue avec l'aide d'une analyse de la hiérarchie du CI au niveau porte et répertorié dans un tableau annexe TAB2'.

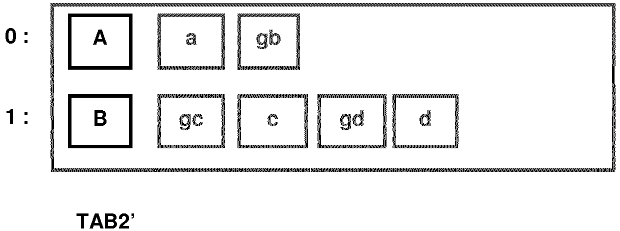

Une entrée est créée pour chaque chemin. La clef est le nom du chemin lu dans TAB2. Les champs valeur comportent les labels.

Pour chaque entrée, le nombre de champs de valeur est égal au nombre de composants physiques ou de modules dans TAB2 pour ce chemin. Un champ de valeur mémorise le label du composant physique.

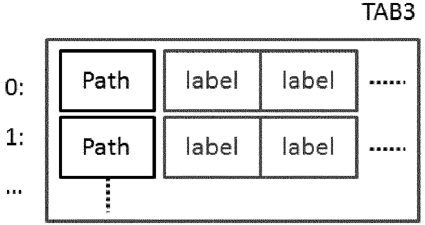

Un label est un motif constitué de deux ou trois champs selon le nombre de paramètre physiques insérés dans les tableaux TAB4 et TAB5 comme il sera détaillé ci-après et pouvant avantageusement intégrer un discriminant.

Le premier champ indique s'il s'agit d'un composant physique représenté (O) ou non (NO) qui constitue un discriminant.

Le second champ contient le nom du composant physique (nom).

Dans le cas où au moins deux paramètres physiques sont utilisés dans TAB4 et/ou TAB5, le second champ définit le numéro du paramètre physique à considérer (param no).

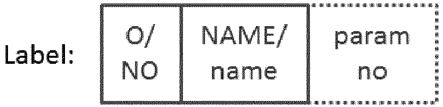

### Etape 4 :

Cette étape consiste en l'extraction des paramètres physiques des composants physiques décrits au niveau d'abstraction considéré.

La simulation peut débuter par l'initialisation des registres et variables et le chargement des données dans les mémoires du circuit. A chaque pas de simulation, des stimuli prédéfinis sont appliqués en entrée du circuit et tous les signaux et registres et variables du système sont évalués. La sortie de la simulation peut fournir une trace des valeurs des signaux, des registres et des variables à chaque pas.

Deux opérations sont combinées dans cette étape :
- une première opération est l'extraction des paramètres physiques des composants physiques représentés, c'est-à-dire ceux décrits dans les deux niveaux d'abstraction et listés à la fois dans TAB1 et TAB2. Cette opération peut s'appuyer avantageusement sur une simulation du circuit au niveau d'abstraction supérieur. Ce paramètre physique est écrit dans le tableau associatif TAB4. Une entrée est créée pour chaque composant physique. La clef est le nom du composant physique (NAME). Chaque entrée peut contenir un ou plusieurs champs. Un champ contient la valeur du paramètre physique du composant physique (Param) (par exemple la fréquence de commutation). 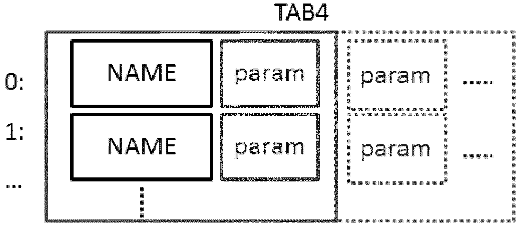
- une deuxième opération est l'extraction du ou des valeurs des paramètres physiques estimés des modules parents, c'est-à-dire ceux listés uniquement dans TAB1. Les paramètres physiques sont extraits à partir d'une simulation/analyse du CI au niveau supérieur seulement ou la simulation/analyse est combinée avec une étape préalable de caractérisation des paramètres physiques qui sera effectuée avec l'aide d'une simulation/analyse au niveau porte. Les paramètres physiques obtenus sont écrits dans le tableau associatif TAB5.

Dans le cas d'un seul chemin, partagé sur plusieurs modules, on attribue une valeur unique pour le paramètre physique du module parent, il n'y a pas de discrimination au niveau des différents composants physiques appartenant à un même module. Le tableau TAB5 a une structure identique à celle du tableau TAB4. Une entrée est créée pour chaque module parent. La clef contient le nom du module parent (NAME). Les champs de valeur mémorisent la valeur du paramètre physique (param).

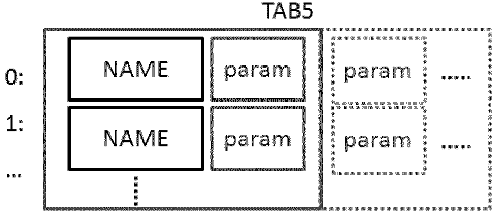

Dans le cas de plusieurs chemins, partagés sur plusieurs modules, on discrimine entre les chemins, les paramètres physiques. Typiquement deux chemins peuvent conduire à deux paramètres physiques pour un même module parent. Le tableau TAB5 est alors formé par le chaînage de deux sous tableaux associatifs. Dans le sous-tableau TAB5.1, une entrée est créée pour chaque module parent. La clef de ce tableau est le nom du module parent. Chaque entrée contient un champ de valeur qui est un pointeur (ptr) sur le sous-tableau TAB.5.2 qui contient le ou les paramètres physiques de chaque chemin traversant ce module parent. Les chemins ont au moins un composant physique non représenté et enfant du module parent. Le nombre de tableaux est égal au plus au nombre d'entrée du tableau TAB5.1. La clef est le nom du chemin. Chaque entrée de ce tableau contient un ou plusieurs champs de valeur. Un champ mémorise le paramètre physique du module parent (param).

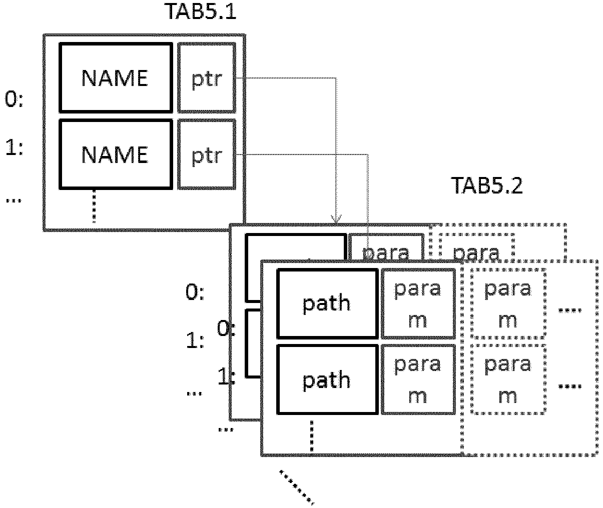

### Etape 5 :

Cette étape combine les tableaux TAB3 avec les tableaux TAB4 et TAB5 afin d'associer le paramètre physique aux composants physiques des chemins. La sortie est le tableau TAB6. Le procédé s'appuie classiquement sur des opérations de lecture, de recherche et d'écriture dans les tableaux associatifs. Les opérations de lecture et écriture accèdent à la clef et aux champs de valeur. L'opération de recherche consiste à déterminer l'index de l'entrée pour laquelle la clef correspond au motif recherché.

Un exemple de réalisation de cette fonction est le parcours séquentiel des clefs depuis la première entrée.

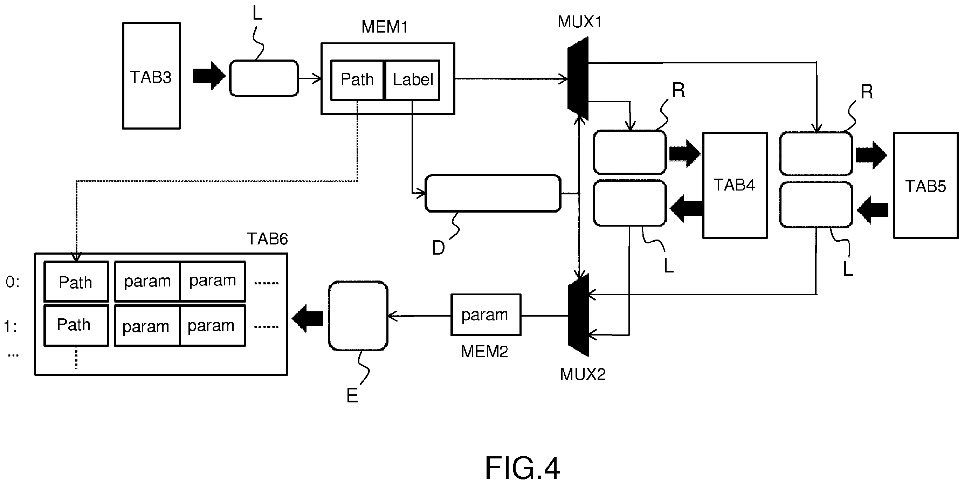

Les entrées de cette étape 5 du procédé sont les tableaux TAB3, TAB4 et TAB5. Les détails de cette étape sont illustrés en figure 4 sur laquelle les opérations suivantes sont référencées comme suit :
- l'opération de lecture : L
- l'opération de recherche : R
- l'opération d'écriture : E
- l'opération de discrimination : D

Cette démarche est exécutée pour chaque entrée et chaque champ de valeur de TAB3. Une exécution débute par la lecture de la clef de l'entrée pointée dans TAB3 (path).

Une boucle d'exécution se déroule ensuite de la manière suivante. La première étape est la lecture du label du premier champ de l'entrée sélectionnée dans TAB3. La clef et la valeur lues sont mémorisées dans la mémoire MEM1.

Le label est ensuite analysé pour déterminer s'il s'agit d'un composant physique représenté ou non (discrimination). S'il s'agit d'un composant physique représenté, le label dans la mémoire MEM1 est envoyé à la fonction de recherche de TAB4 sinon le contenu de MEM1 est envoyé à celle du tableau TAB5, via un multiplexeur MUX1.

Dans la seconde variante, la fonction de recherche du tableau TAB5.1 reçoit en entrée le label. Celle du tableau TAB5.2 reçoit en entrée le nom du chemin (path).

Après détermination de l'entrée, la fonction de lecture du tableau TAB5 récupère la valeur du paramètre physique (lorsque plusieurs champs existent, le numéro du champ à lire est contenu dans le label). Le paramètre physique lu est mémorisé dans la mémoire MEM2. Son contenu et le nom du chemin (MEM1) sont finalement écrits dans le tableau TAB6 ayant une structure identique à celle du tableau TAB3 (figure 4). Le nombre d'entrée via le multiplexeur MUX2 sera égal à celui de TAB3. Une entrée est créée pour chaque chemin. La clef est le nom du chemin en cours de lecture dans MEM1. Le nombre de champs de valeur est égal au nombre de signaux du chemin courant. Le champ de valeur TAB6 reçoit la valeur contenue dans MEM2. Un champ sera créé à chaque boucle d'exécution.

Lorsqu'un seul chemin, est à considérer, les paramètres d'un composant physique parent sont donc partagés par tous ses composants physiques enfants. Dans la deuxième variante de TAB5, l'opération assigne les paramètres physiques des composants physiques parent aux chemins « enfants » séparément : deux composants physiques enfants d'un même parent peuvent avoir deux valeurs différentes du même paramètre physique.

Les tableaux TAB4 et TAB5/TAB5.1 peuvent être combinés dans un même tableau. Le champ de valeur indique également s'il s'agit d'une valeur de paramètre physique ou d'un pointeur.

La notion de paramètre physique d'un parent peut correspondre à la fréquence de commutation moyenne des signaux internes (enfants), au maximum/minimum des fréquences de commutation des signaux internes ou à la puissance consommée du module ou à la température du module ou le délai de propagation d'un signal sur la ligne de métal.

Le procédé décrit ci-dessus intervient après simulation du CI au niveau RTL (ou supérieur). Le procédé (étape 5) peut être exécuté également pendant la simulation du CI à chaque pas de simulation ou de manière périodique entre plusieurs pas de simulation.

### Exemple de mise en oeuvre du procédé de l'invention au niveau RTL:

Considérons l'exemple d'un CI composé d'un chemin P réparti sur 2 modules A et B, décrits au niveau RTL. Seuls les signaux des chemins sont considérés. Le paramètre physique étudié est la fréquence de commutation du signal ou l'activité, c'est-à-dire le ratio entre le nombre de cycles d'horloge du CI et le nombre de changements de sa valeur (0 à 1 et vice versa).

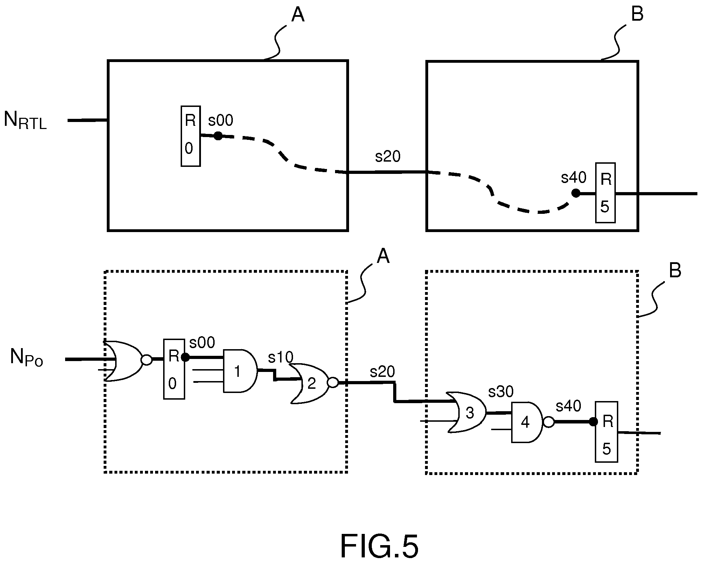

L'exemple est illustré sur la figure 5. Seuls les signaux (composant physiques) utiles à l'exemple sont décrits au niveau porte.

Après réalisation des Etapes 1 et 2, les tableaux TAB1 et TAB2 sont définis comme représentés ci-après :

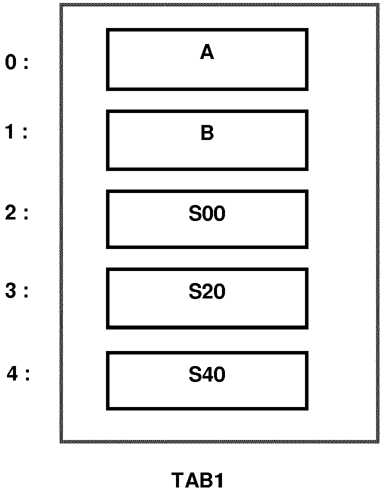

A, B étant les noms des modules, s00, s20 et s40 étant les noms des composants physiques représentés.

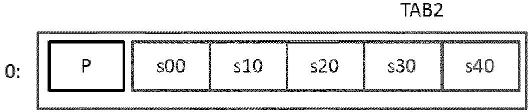

Le tableau TAB2 comporte une seule entrée correspondant au chemin dont le nom P est indiqué dans le champ clef.

s00, s10, s20, s30 et s40 sont inscrits dans les champs valeur indiquant les noms des signaux issus des composants physiques. On assimilera par la suite, les signaux aux composants dont ils sont issus. Un signal observable correspond à un composant représenté et un signal non observable à un composant non représenté.

### Etape 3 :

Dans la réalisation de l'étape 3, le tableau de label TAB3 ci-après est défini. Dans le tableau TAB2, les signaux s00, s20 et s40 sont représentés (label avec motif O) alors que les signaux s10, s30 et s40 ne le sont pas (label avec comme discriminant le motif NO). Les signaux s10, s30 et s40 sont labellisés respectivement avec les modules A et B d'appartenance.

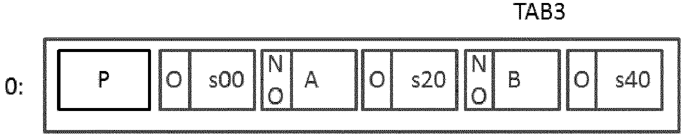

### Etape 4 :

### 4.1. : Réalisation de la Table TAB4 :

Après simulation du circuit au niveau RTL, les valeurs des signaux s00, s20 et s40 et le nombre de cycles de simulation sont collectés. La fréquence de commutation des signaux AC est calculée et écrite dans le tableau TAB4.

Le tableau contient trois entrées (trois signaux représentés). Le nom du signal est écrit dans le champ clef et la valeur du paramètre physique AC est écrite dans le champ de valeur.

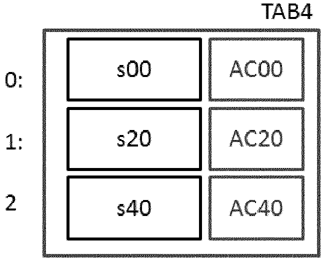

### 4.2 : Réalisation de la Table TAB5 :

Concernant l'estimation de l'activité des modules A et B, une approche assez précise est de caractériser l'activité des signaux internes des modules.

La procédure débute avec une description porte du CI. Un ensemble de stimuli d'entrée est généré de manière aléatoire. La simulation du circuit est effectuée avec ces stimuli. L'activité totale des signaux AC du chemin est calculée pour chaque module séparément : AC_{A} pour le module A et AC_{B} pour le module B, permettant de définir l'activité qui pourra être associée aux composants physiques non-représentés.

La deuxième variante de TAB5 est la meilleure réalisation (meilleure précision).

Pour le module A, la valeur AC_{A} correspond à la somme des activités des signaux s00 et s10. Une entrée est créée dans TAB5.1. Le champ clef reçoit le symbole A et le champ valeur contient le pointeur permettant de pointer le tableau TAB5.2 relatif au module A.

Le tableau TAB5.2 relatif au module A est créé avec une entrée. Les symboles P et ACa sont écrits respectivement dans le champ clef et dans le champ valeur.

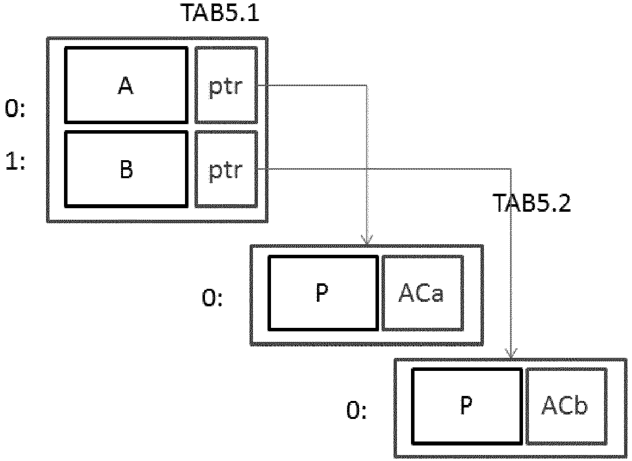

### Etape 5 :

Au cours de cette étape, on sélectionne le premier chemin P dans TAB3. Une entrée est créée dans le tableau TAB6 et l'identifiant « P » est écrit dans le champ clef. Le premier champ de valeur s00 est lu.

Le label « O|s00 » correspond au signal représenté « s00 » ; le tableau TAB4 est sélectionné et le nom « s00 » est recherché dans la clef des entrées de TAB4. La valeur AC00 est écrite dans le premier champ de valeur de TAB6. Le second champ de TAB3 contient le label « NO|A » ; le signal est non observable. Le tableau TAB5.1 est sélectionné puis le nom « A » est recherché dans la clef des entrées de ce tableau. Le tableau TAB5.2 est sélectionné puis le symbole « P » est recherché dans la clef des entrées. Enfin, le champ de valeur est lu. Le contenu ACa sera écrit dans le 2^{nd} champ de la première entrée (0:) de TAB6.

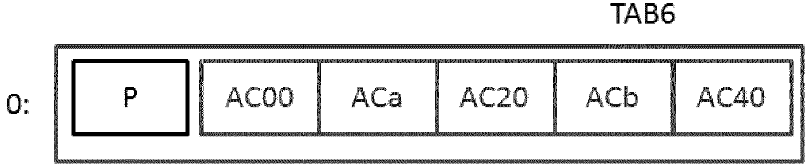

Il est ainsi possible de calculer l'activité totale du chemin « P » au niveau RTL (somme des champs de valeurs du tableau TAB6 associés à la clef P) ou la dégradation du temps de propagation du chemin en insérant les champs de valeur dans l'équation donnée dans l'article de Clement Bertolini, Olivier Héron, Nicolas Ventroux, François Marc, "Relation between HCl-induced performance degradation and applications in a RISC processor", IOLTS 2012.

### Exemple de procédé de l'invention utilisant un niveau supérieur de RTL :

Le procédé peut également être appliqué au niveau transactionnel-comportemental (TLM), le CI est décrit avec des modules comportementaux (par exemple une mémoire ou une unité de calcul ou une unité de contrôle) et des ports ou interfaces TLM qui connectent les modules entre eux (langage SystemC).

En général, seul le comportement du composant est décrit dans le module (assez similaire à une machine d'états). Le langage SystemC offre une liberté dans la manière de décrire le système. Il y a néanmoins des règles pour attribuer un nom aux variables à respecter pour garantir le bon déroulement de l'opération de labellisation.

Etant donné que la notion de signal est également présente dans le langage SystemC, le nom d'un signal SystemC doit exister également dans la description porte du CI.

Une interface TLM est matérialisée par une structure de donnée qui est lue et écrite par les modules. La structure contient une ou plusieurs variables d'un type prédéfini (par exemple entier 32 bits).

La structure de donnée modélise le comportement d'un groupe de signaux réels. Il doit exister une correspondance entre le nom des signaux au niveau porte et le nom des variables dans cette structure.

## Revendications

1. Procédé d'analyse du comportement d'un circuit intégré comprenant des chemins et composants physiques, mis en oeuvre par ordinateur,
- lesdits composants physiques étant soit non représentés dans un premier niveau d'abstraction au moins égal ou supérieur au niveau RTL, soit représentés dans ledit premier niveau d'abstraction ;
- ledit circuit intégré comprenant un ensemble de modules (A, B) constitués de composant(s) physiques(s) ;
- chaque module définissant une fonction entre un signal d'entrée et un signal de sortie,
- les composants physiques, les chemins et les modules étant identifiés chacun par un nom,
ledit procédé **caractérisé en ce qu'**il comprend en outre les étapes suivantes :
- une première étape (1), générant un premier tableau (TAB1), d'extraction d'un premier ensemble de noms correspondant aux composants physiques représentés et aux modules;
- une seconde étape (2), générant deux tableaux associatifs (TAB2, TAB2'), comprenant l'extraction des noms des chemins et ceux des composants physiques pour chacun desdits chemins et l'assignation d'un nom de module d'appartenance auxdits composants physiques ;
- une troisième étape (3), générant un troisième tableau associatif (TAB3), attribuant un label à l'ensemble des composants physiques, ledit label étant :
∘ leur nom pour les composants représentés par un nom dans les premier (TAB1) et deux tableaux associatifs (TAB2, TAB2') ;
∘ le nom du module d'appartenance pour les composants non représentés par un nom dans les premier (TAB1) et deux tableaux associatifs (TAB2, TAB2') ;
- une quatrième étape (4), générant des quatrième et cinquième tableaux associatifs (TAB4, TAB5), de détermination d'au moins un paramètre physique pour chacun des composants représentés et pour chacun des modules, et d'association des noms des composants représentés aux paramètres physiques déterminés, et d'association des noms des composants représentés et d'association des noms des modules aux paramètres physiques déterminés, et où ledit au moins un paramètre physique pouvant être la fréquence de commutation d'un signal ou le temps de maintien d'un signal ou l'activité correspondant au ratio entre un nombre (total) de changement de valeur ou un nombre de cycles de maintien à 1 ou un nombre de cycles de maintien à 0 d'un signal et le nombre de cycles du signal d'horloge ou le délai de propagation d'une cellule logique ; et
- une cinquième étape (5) d'assignation des paramètres physiques contenus dans les quatrième et cinquième tableaux associatifs (TAB4, TAB5) aux composants physiques contenus dans le troisième tableau associatif (TAB3), la cinquième étape générant un sixième tableau associatif (TAB6) dont le contenu permet le calcul de l'activité totale du chemin ou de la dégradation du temps de propagation du chemin.

2. Procédé d'analyse du comportement d'un circuit intégré mis en oeuvre par ordinateur selon la revendication 1, **caractérisé en ce que** les paramètres physiques des composants physiques représentés sont obtenus par simulation/analyse du circuit au niveau supérieur.

3. Procédé d'analyse du comportement d'un circuit intégré mis en oeuvre par ordinateur, selon l'une des revendications 1 ou 2, **caractérisé en ce que** l'assignation d'un module à un composant physique non représenté est réalisée par l'analyse de la hiérarchie du circuit intégré au niveau porte.

4. Procédé d'analyse du comportement d'un circuit intégré mis en oeuvre par ordinateur, selon l'une des revendications 1 à 3, **caractérisé en ce qu'**au moins un module étant traversé par plusieurs chemins, la quatrième étape de détermination d'au moins un paramètre physique pour chacun des modules comprend :
- une étape de chaînage d'au moins deux sous-étapes :
∘ une première sous-étape de pointage des chemins traversant chaque module (TAB5.1) ;
∘ une seconde sous-étape de détermination pour chaque chemin pointé, du paramètre physique associé audit module (TAB5.2).

5. Procédé d'analyse du comportement d'un circuit intégré mis en oeuvre par ordinateur, selon l'une des revendications 1 à 4, **caractérisé en ce que** la troisième étape attribuant un label à l'ensemble des composants physiques comporte en outre l'affectation d'un discrimant de l'état représenté et non représenté, à chacun des composants physiques (O, NO).

6. Procédé d'analyse du comportement d'un circuit intégré mis en oeuvre par ordinateur, selon l'une des revendications 1 à 5, **caractérisé en ce qu'**il comprend la construction de tableaux (TAB2, TAB2', TAB3, TAB4, TAB5) associatifs avec des clef d'entrée et des champs valeurs pour exploiter les résultats des seconde, troisième, quatrième et cinquième étapes.

7. Procédé d'analyse du comportement d'un circuit intégré mis en oeuvre par ordinateur, selon l'une des revendications 1 à 5, **caractérisé en ce que** le premier niveau d'abstraction au moins égal ou supérieur au niveau RTL est un niveau transactionnel-comportemental (TLM), les modules étant des modules comportementaux pouvant comprendre au moins une mémoire ou une unité de calcul ou une unité de contrôle et des ports ou interfaces TLM qui connectent les modules entre eux.

8. Procédé d'analyse du comportement d'un circuit intégré mis en oeuvre par ordinateur, comprenant :
- les étapes du procédé d'analyse fonctionnelle, mis en oeuvre par ordinateur, d'un circuit intégré selon l'une des revendications 1 à 7 ;
- dont une succession d'au moins deux séries d'opérations décalées dans le temps pour :
∘ ladite quatrième étape de détermination d'au moins un paramètre physique pour chacun des composants représentés et pour chacun des modules, et d'association des noms des composants représentés et des noms des modules, avec les paramètres physiques déterminés, la détermination d'au moins un paramètre physique pour les composants physiques représentés permettant d'établir un quatrième tableau associatif (TAB4) comportant le nom des composants physiques et leur paramètre physique associé ;
- une étape de comparaison des cinquièmes étapes d'assignation de paramètre physiques déterminés et nommés dans la quatrième étape, aux composants physiques nommés dans la seconde étape d'extraction, permettant de suivre l'évolution temporelle dudit circuit intégré.

9. Programme d'ordinateur comportant des instructions pour l'exécution du procédé d'analyse du comportement d'un circuit intégré mis en oeuvre par ordinateur, selon l'une quelconque des revendications 1 à 8, lorsque le programme est exécuté par un processeur.

10. Module de conception destiné à être embarqué dans un circuit intégré comportant au moins une unité de calcul et une mémoire, mettant en oeuvre le procédé d'analyse du comportement d'un circuit intégré mis en oeuvre par ordinateur selon l'une quelconque des revendications 1 à 8.

## Patentansprüche

1. Verfahren zur Analyse des Verhaltens einer integrierten Schaltung, welche physische Pfade und Komponenten beinhaltet, welches durch einen Computer umgesetzt wird,
- wobei die physischen Komponenten entweder in einem ersten Abstraktionsniveau nicht dargestellt sind, welches mindestens gleich oder höher ist als das RTL-Niveau, oder in diesem ersten Abstraktionsniveau dargestellt sind;
- wobei die integrierte Schaltung eine Gruppe von Modulen (A, B) beinhaltet, welche aus einer oder mehreren physischen Komponente(n) gebildet sind;
- wobei jedes Modul eine Funktion zwischen einem Eingangssignal und einem Ausgangssignal definiert,
- wobei die physischen Komponenten, die Pfade und die Module jeweils durch einen Namen definiert sind,
- wobei das Verfahren **dadurch gekennzeichnet ist, dass** es zudem folgende Schritte beinhaltet:
- einen ersten Schritt (1), bei welchem eine erste Tabelle (TAB1) zur Extraktion einer ersten Gruppe von Namen erzeugt wird, welche den dargestellten physischen Komponenten und den Modulen entsprechen;
- einen zweiten Schritt (2), bei welchem zwei assoziative Tabellen (TAB2, TAB2') erzeugt werden, welche die Extraktion der Namen der Pfade und die Namen der physischen Komponenten für jeden dieser Pfade, und die Zuweisung eines Namens eines Zugehörigkeitsmoduls an die physischen Komponenten beinhalten;
- einen dritten Schritt (3), bei welchem eine dritte assoziative Tabelle (TAB3) erzeugt wird, welche einer Gruppe von physischen Komponenten ein Label zuordnet, wobei dieses Label Folgendes ist:
* ihr Name für die in der ersten (TAB1) der beiden assoziativen Tabellen (TAB2, TAB2') dargestellten Komponenten;
* der Name des Zugehörigkeitsmoduls für die nicht durch einen Namen in der ersten (TAB1) und in den beiden assoziativen Tabellen (TAB2, TAB2') dargestellten Komponenten;
- einen vierten Schritt (4), bei welchem eine vierte und eine fünfte assoziative Tabelle (TAB4, TAB5) erzeugt werden, zur Bestimmung von mindestens einem physischen Parameter für jede der dargestellten Komponenten und für jedes der Module, und zur Assoziation der Namen der dargestellten Komponenten und zur Assoziation der Namen der Module mit den bestimmten physischen Parametern, und wobei der mindestens eine physische Parameter die Umschaltfrequenz eines Signals oder die Haltezeit eines Signals oder die Aktivität sein kann, welche dem Verhältnis zwischen einer Zahl (Summe) der Wertänderung oder einer Anzahl von Haltezyklen bei 1 oder einer Anzahl von Haltezyklen bei 0 eines Signals und der Anzahl von Zyklen des Uhrsignals oder der Fortpflanzungszeit einer logischen Zelle entspricht; und
- einen fünften Schritt (5) der Zuweisung der physischen Parameter, welche in der vierten und der fünften assoziativen Tabelle (TAB4, TAB5) enthalten sind, an die in der dritten assoziativen Tabelle (TAB3) enthaltenen physischen Komponenten, wobei der fünfte Schritt eine sechste assoziative Tabelle (TAB6) erzeugt, deren Inhalt die Berechnung der Gesamtaktivität des Pfades oder der Verschlechterung der Propagationszeit des Pfades ermöglicht.

2. Verfahren zur Analyse des Verhaltens einer integrierten Schaltung, welches durch einen Computer umgesetzt wird, nach Anspruch 1, **dadurch gekennzeichnet, dass** die physischen Parameter der dargestellten physischen Komponenten anhand Simulation/Analyse der Schaltung auf dem höheren Niveau erzielt werden.

3. Verfahren zur Analyse des Verhaltens einer integrierten Schaltung, welches durch einen Computer umgesetzt wird, nach einem der Ansprüche 1 oder 2, **dadurch gekennzeichnet, dass** die Zuweisung eines Moduls an eine nicht dargestellte physische Komponente anhand der Analyse der Hierarchie der integrierten Schaltung auf Höhe des Gates erfolgt.

4. Verfahren zur Analyse des Verhaltens einer integrierten Schaltung, welches durch einen Computer umgesetzt wird, nach einem der Ansprüche 1 bis 3, **dadurch gekennzeichnet, dass**, da mindestens ein Modul durch mehrere Pfade durchquert wird, der vierte Schritt des Bestimmens von mindestens einem physischen Parameter für jedes der Module Folgendes beinhaltet:
- einen Schritt der Verkettung von mindestens zwei Unterschritten:
* eines ersten Unterschrittes der Abzählung der Pfade, welche ein jedes Modul (TAB5. 1) durchqueren;
* eines zweiten Unterschrittes der Bestimmung, für jeden abgezählten Pfad, des mit dem Modul (TAB5.2) assoziierten physischen Parameters.

5. Verfahren zur Analyse des Verhaltens einer integrierten Schaltung, welches durch einen Computer umgesetzt wird, nach einem der Ansprüche 1 bis 4, **dadurch gekennzeichnet, dass**, da der dritte Schritt der Gruppe von physischen Komponenten ein Label zuordnet, er zudem die Zuordnung, zu jeder der physischen Komponenten (O, NO), eines Unterscheidungsfaktors des dargestellten und des nicht dargestellten Zustandes beinhaltet.

6. Verfahren zur Analyse des Verhaltens einer integrierten Schaltung, welches durch einen Computer umgesetzt wird, nach einem der Ansprüche 1 bis 5, **dadurch gekennzeichnet, dass** es die Konstruktion von assoziativen Tabellen (TAB2, TAB2', TAB3, TAB4, TAB5) mit Eingabe-Schlüsseln und Wertefeldern zur Auswertung der Resultate des zweiten, des dritten, des vierten und des fünften Schrittes beinhaltet.

7. Verfahren zur Analyse des Verhaltens einer integrierten Schaltung, welches durch einen Computer umgesetzt wird, nach einem der Ansprüche 1 bis 5, **dadurch gekennzeichnet, dass** das erste Abstraktionsniveau, welches gleich oder höher ist als das RTL-Niveau, ein Transaktions-Verhaltens-Niveau (TLM) ist, wobei die Module Verhaltensmodule sind, welche mindestens einen Speicher oder eine Recheneinheit oder eine Steuereinheit und TLM-Ports oder -Schnittstellen beinhalten können, welche die Module miteinander verbinden.

8. Verfahren zur Analyse des Verhaltens einer integrierten Schaltung, welches durch einen Computer umgesetzt wird und welches Folgendes beinhaltet:
- die Schritte des Funktionsanalyseverfahrens, welches durch einen Computer umgesetzt wird, einer integrierten Schaltung nach einem der Ansprüche 1 bis 7;
- darunter eine Abfolge von mindestens zwei Serien von zeitlich versetzten Operationen für:
* den vierten Schritt des Bestimmens von mindestens einem physischen Parameter für jede der dargestellten Komponenten und für jedes der Module, und des Assoziierens der Namen der dargestellten Komponenten und der Namen der Module, mit den bestimmten physischen Parametern, wobei die Bestimmung von mindestens einem physischen Parameter für die dargestellten physischen Komponenten es ermöglicht, eine vierte assoziative Tabelle (TAB4) zu erstellen, welche den Namen der physischen Komponenten und ihren assoziierten physischen Parameter beinhaltet;
- den Schritt des Vergleichens des fünften Schrittes der Zuweisung von physischen Parametern, welche im vierten Schritt bestimmt und benannt werden, mit im zweiten Schritt des Extrahieren benannten physischen Komponenten, welcher es ermöglicht, die zeitliche Entwicklung der integrierten Schaltung zu überwachen.

9. Computerprogramm, beinhaltend Anweisungen zur Ausführung des Analyseverfahrens des Verhaltens einer integrierten Schaltung, welches durch einen Computer umgesetzt wird, nach einem der Ansprüche 1 bis 8, wenn das Programm von einem Prozessor ausgeführt wird.

10. Konzeptionsmodul, bestimmt zum Einbau an Bord einer integrierten Schaltung, welche mindestens eine Recheneinheit und einen Speicher beinhaltet, welches das Analyseverfahren des Verhaltens einer integrierten Schaltung, welches durch einen Computer umgesetzt wird, nach einem der Ansprüche 1 bis 8 umsetzt.

## Claims

1. A method for analyzing the behavior of an integrated circuit comprising paths and physical components, implemented by computer,
- said physical components being either not represented in a first level of abstraction at least equal to or higher than the RTL level, or represented in said first level of abstraction;
- said integrated circuit comprising a set of modules (A, B) consisting of physical component(s);
- each module defining a function between an input signal and an output signal,
- the physical components, the paths and the modules each being identified by a name,
said method being **characterized in that** it further comprises the following steps:
- a first step (1), generating a first array (TAB1), of extracting a first set of names corresponding to the physical components represented and to the modules;
- a second step (2), generating two associative arrays (TAB2, TAB2'), comprising the extraction of the names of the paths and those of the physical components for each of said paths and the assignment of a membership module name to said physical components;
- a third step (3), generating a third associative array (TAB3), allotting a label to the set of physical components, said label being:
∘ their name for the components represented by a name in the first (TAB1) and two associative arrays (TAB2, TAB2');
∘ the name of the membership module for the components not represented by a name in the first (TAB1) and two associative arrays (TAB2, TAB2');
- a fourth step (4), generating fourth and fifth associative arrays (TAB4, TAB5), of determining at least one physical parameter for each of the components represented and for each of the modules, and of associating the names of the components represented with the physical parameters determined, and of associating the names of the components represented and of associating the names of the modules with the physical parameters determined, and where said at least one physical parameter being able to be the switching frequency of a signal or the holding time of a signal or the activity corresponding to the ratio between a (total) number of change of value or a number of cycles of holding at 1 or a number of cycles of holding at 0 of a signal and the number of cycles of the clock signal or the propagation lag of a logic cell; and
- a fifth step (5) of assigning the physical parameters contained in the fourth and fifth associative arrays (TAB4, TAB5) to the physical components contained in the third associative array (TAB3), the fifth step generating a sixth associative array (TAB6) whose content allows the calculation of the total activity of the path or of the degradation of the propagation time of the path.

2. The method for analyzing the behavior of an integrated circuit implemented by computer as claimed in claim 1, **characterized in that** the physical parameters of the physical components represented are obtained by simulation/analysis of the circuit at the higher level.

3. The method for analyzing the behavior of an integrated circuit implemented by computer, according to any of claims 1 or 2, **characterized in that** the assignment of a module to a physical component not represented is carried out by the analysis of the hierarchy of the integrated circuit at the gate level.

4. The method for analyzing the behavior of an integrated circuit implemented by computer, according to any of claims 1 to 3, **characterized in that** at least one module being traversed by several paths, the fourth step of determining at least one physical parameter for each of the modules comprises:
- a step of stringing together at least two sub-steps:
∘ a first sub-step of pointing at the paths traversing each module (TAB5.1);
∘ a second sub-step of determining for each path pointed at, the physical parameter associated with said module (TAB5.2).

5. The method for analyzing the behavior of an integrated circuit implemented by computer, according to any of claims 1 to 4, **characterized in that** the third step allotting a label to the set of physical components furthermore comprises the assigning of a discriminant of the state represented and not represented, to each of the physical components (O, NO).

6. The method for analyzing the behavior of an integrated circuit implemented by computer, according to any of claims 1 to 5, **characterized in that** it comprises the construction of associative arrays (TAB2, TAB2', TAB3, TAB4, TAB5) with input keys and value fields so as to utilize the results of the second, third, fourth and fifth steps.

7. The method for analyzing the behavior of an integrated circuit implemented by computer, according to any of claims 1 to 5, **characterized in that** the first level of abstraction at least equal to or higher than the RTL level is a transactional-behavioral level (TLM), the modules being behavioral modules that may comprise at least one memory or a calculation unit or a control unit and TLM ports or interfaces which connect the modules together.

8. A method for analyzing the behavior of an integrated circuit implemented by computer, comprising:
- the steps of the method of functional analysis, implemented by computer, of an integrated circuit according to any of claims 1 to 7;
- including a succession of at least two series of operations shifted in time for:
∘ said fourth step of determining at least one physical parameter for each of the components represented and for each of the modules, and of associating the names of the components represented and the names of the modules, with the physical parameters determined, the determination of at least one physical parameter for the physical components represented making it possible to establish a fourth associative array (TAB4) comprising the name of the physical components and their associated physical parameter;
- a step of comparing of the fifth steps of assigning physical parameters determined and named in the fourth step, to the physical components named in the second extracting step, making it possible to follow the temporal evolution of said integrated circuit.

9. A computer program comprising instructions for the execution of the method for analyzing the behavior of an integrated circuit implemented by computer, according to any of claims 1 to 8, when the program is executed by a processor.

10. A design module intended to be embedded onboard an integrated circuit comprising at least one calculation unit and a memory, implementing the method for analyzing the behavior of an integrated circuit implemented by computer according to any of claims 1 to 8.
